# DEMANDE DE BREVET EUROPEEN

(11) **EP 4 030 486 A1**
(43) Date de publication de la demande: **20.07.2022**
(21) Numéro de dépôt: 22151919.2
(22) Date de dépôt: 18.01.2022
(51) Int. Cl.: H01L 29/16, H01L 29/40, H01L 29/423, H01L 29/66, B82Y 10/00

(54) **PROCÉDÉ DE FABRICATION DE GRILLES D'ÉCHANGE AUTO-ALIGNÉES POUR UN DISPOSITF QUBIT ET DISPOSITIF QUBIT SEMI-CONDUCTEUR ASSOCIÉ**

(30) Priorité: 18.01.2021 FR 2100439
(71) Demandeur: Commissariat à l'Energie Atomique et aux Energies Alternatives, 75015 Paris (FR)
(72) Inventeur: NIEBOJEWSKI, Heimanu, 38054 GRENOBLE CEDEX 09 (FR)
(74) Mandataire: Cabinet Camus Lebkiri

(57) **Abrégé**

Un aspect de l'invention concerne un procédé de fabrication de grilles d'échange (remplaçant les espaceurs ME) pour un dispositif qubit à boites quantiques, à partir d'une structure de départ comprenant un substrat (Si, BOX) et, disposés sur le substrat, une pluralité d'empilements de grille, chaque empilement de grille comprenant, une couche d'un matériau conducteur (MC) ou semi-conducteur ainsi qu'une couche d'un masque dur (MD), le procédé comprenant : une étape de dépôt conforme d'une couche de liner (LI) sur la structure de départ ; une étape de dépôt conforme d'une couche d'un matériau espaceur (ME) sur la couche de liner, l'épaisseur de la couche d'un matériau espaceur étant choisie de sorte à combler l'espace entre les empilements de grille ; une étape de gravure anisotrope de la couche de matériau espaceur ; une étape de gravure anisotrope de la couche de liner ; une étape de dépôt d'une couche d'arrêt sur l'ensemble de la structure intermédiaire obtenue à l'issue des étapes précédentes ; une étape de dépôt d'une couche d'encapsulation sur la couche d'arrêt ; une première étape de photolithographie de sorte à réaliser des ouvertures débouchant au niveau des empilements de grille (MC), les ouvertures étant destinées à recevoir des contacts électriques ; une étape de dépôt d'une couche de protection de sorte à protéger les zones exposées lors de la première étape de lithographie ; une deuxième étape de photolithographie réalisant des ouvertures exposant la couche d'un matériau espaceur située entre les empilements de grille ; une étape de gravure sélective de la couche du matériau espaceur exposée lors de l'étape de photolithographie précédente une étape de formation des contacts dans les ouvertures réalisées lors de la deuxième étapes de lithographie et de l'étape de gravure sélective de la couche du matériau espaceur ; et une étape de formation des contacts dans les ouvertures réalisées lors de la première étape de photolithographie, de la deuxième étapes de photolithographie et de l'étape de gravure sélective de la couche du matériau espaceur de sorte à obtenir les grilles d'échange. Les grilles (MC) modulent le potentiel des boites quantiques du dispositif qubit et les grilles d'échange (remplaçant les espaceurs ME) contrôlent le couplage entre les boites quantiques.

## Description

### DOMAINE TECHNIQUE DE L'INVENTION

Le domaine technique de l'invention est celui de la fabrication de dispositif semi-conducteurs.

La présente invention concerne la fabrication de grilles d'échange et en particulier un procédé de fabrication de grilles d'échange auto-alignées pour des applications à l'informatique quantique.

### ARRIERE-PLAN TECHNOLOGIQUE DE L'INVENTION

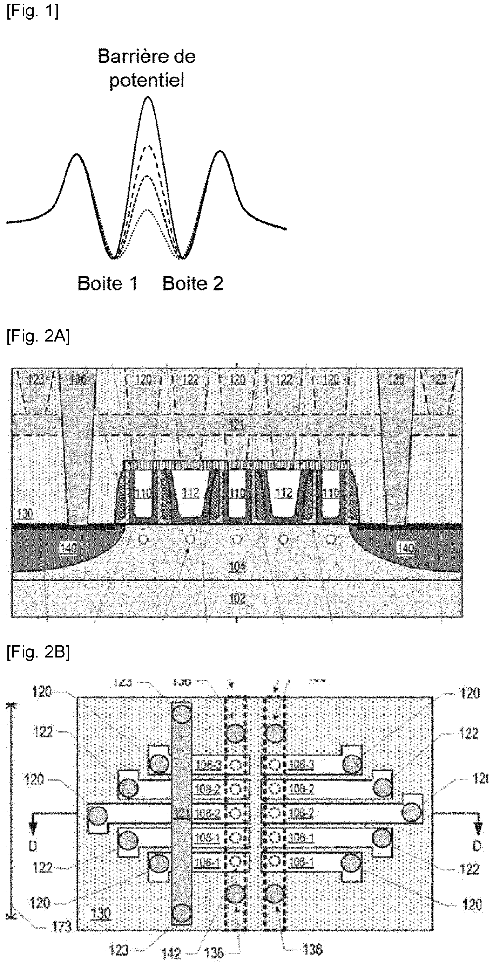

Dans le domaine de l'informatique quantique, il est courant de confiner dans une boite quantique un ou plusieurs électrons afin de manipuler leurs états. Il est également courant d'utiliser une pluralité de boites quantiques afin de réaliser des opérations plus complexes. De manière générale, le potentiel au niveau de chaque boite quantique est modulé au moyen d'une première grille, dite grille principale dans la suite du texte, tandis que le couplage entre les deux boites quantiques (autrement dit, la hauteur de potentiel séparant deux boites quantiques) est modulé par une deuxième grille, dite grille d'échange dans la suite du texte. Le potentiel électrostatique ainsi obtenu est illustré à la figure 1 dans le cas d'une première boite quantique et d'une deuxième boite quantique séparées l'une de l'autre par une barrière de potentiel, la hauteur de la barrière de potentiel (et donc le couplage entre les deux boites quantiques) étant modulée à l'aide de la grille d'échange. Ainsi, les dispositifs utilisés se présentent généralement sous la forme du dispositif décrit dans le document WO2017213658, visible à la figure 2A (vue de côté) et à la figure 2B (vue de dessus). Sur ces figures, les références 110 correspondent aux grilles principales tandis que les références 112 correspondent aux grilles d'échange. En outre, les grilles principales sont contactées à l'aide d'une première série d'électrodes référencées 120 tandis que les grilles d'échange sont contactées à l'aide d'une deuxième série d'électrodes référencées 122.

Cependant, le procédé de fabrication d'un tel dispositif proposé dans ce document présente deux inconvénients. Premièrement, l'absence de court-circuit entre les grilles principales et les grilles d'échange repose uniquement sur la qualité de l'alignement des contacts et des grilles. Il y a donc un fort risque de court-circuit en cas de mauvais alignement. Aussi, afin de réduire ce risque, comme cela est illustré à la figure 2B, la première série et la deuxième série d'électrodes sont déportées par rapport à l'axe d'alignement des grilles principales et d'échange afin de limiter les risques de court-circuit entre les grilles d'échange et les grilles principales. La surface occupée par un dispositif ainsi obtenu est donc relativement importante ce qui réduit d'autant la densité de dispositifs qu'il est possible d'atteindre.

Plus généralement, l'examen de l'état de la technique montre que les solutions proposées font appel à des procédés de fabrication complexes comprenant un grand nombre d'étapes de polissage mécano-chimique (par ex. WO2017213658) et présentent de forts risques de courts-circuits entre les grilles principales et les grilles d'échanges nécessitant d'adopter une reprise de contact déportée pour les grilles principales et les grilles d'échange.

Il existe donc un besoin de fournir un procédé qui permet de réduire le risque de court-circuit entre les grilles principales et les grilles d'échange. Il existe également un besoin de fournir un procédé qui permet de réduire la surface occupée par un dispositif susceptible d'être utilisé pour la formation de boites quantiques couplées.

### RESUME DE L'INVENTION

L'invention offre une solution aux problèmes évoqués précédemment, en permettant d'obtenir des grilles d'échange auto-alignées avec les grilles principales, réduisant ainsi drastiquement les risques de court-circuit entre les grilles. En outre, dans le procédé selon l'invention, les contacts électriques associé aux grilles d'échange ne sont pas déportés réduisant la surface occupée par le dispositif ainsi obtenu.

Un aspect de l'invention concerne un procédé de fabrication de grilles d'échange auto-alignées à partir d'une structure de départ comportant un substrat et, disposés sur le substrat, une pluralité d'empilements de grille, chaque empilement de grille comprenant une couche d'un matériau conducteur ou semi-conducteur ainsi qu'une couche d'un masque dur, le procédé comprenant :
- une étape de dépôt conforme d'une couche de liner sur la structure de départ ;
- une étape de dépôt conforme d'une couche d'un matériau espaceur sur la couche de liner, l'épaisseur de la couche d'un matériau espaceur étant choisie de sorte à combler l'espace entre les empilements de grille ;
- une étape de gravure anisotrope de la couche de matériau espaceur ;
- une étape de gravure anisotrope de la couche de liner ;
- une étape de dépôt d'une couche d'arrêt sur l'ensemble de la structure intermédiaire obtenue à l'issue des étapes précédentes ;
- une étape de dépôt d'une couche d'encapsulation sur la couche d'arrêt ;
- une première étape de photolithographie de sorte à réaliser, dans la couche d'arrêt et la couche d'encapsulation, les ouvertures débouchant au niveau des empilements de grille, les ouvertures étant destinées à recevoir des contacts électriques ;
- une étape de dépôt d'une couche de protection de sorte à protéger les zones exposées lors de la première étape de photolithographie ;
- une deuxième étape de photolithographie réalisant des ouvertures exposant la couche d'un matériau espaceur situé entre les empilements de grille ;
- une étape de gravure sélective de la couche du matériau espaceur exposée lors de l'étape de photolithographie précédente ;
- une étape de formation des contacts dans les ouvertures réalisées lors de la première étape de photolithographie, de la deuxième étapes de photolithographie et de l'étape de gravure sélective de la couche du matériau espaceur de sorte à obtenir les grilles d'échanges.

Grâce à l'invention, il est possible d'obtenir des grilles d'échange auto-alignées avec les grilles principales, ce qui permet de réduire fortement les risques de court-circuit. En outre, les contacts des grilles d'échanges ne sont pas déportés mais réalisées directement au-dessus des grilles d'échange, ce qui permet de réduire la surface du dispositif ainsi obtenu.

Outre les caractéristiques qui viennent d'être évoquées dans le paragraphe précédent, le procédé selon un premier aspect de l'invention peut présenter une ou plusieurs caractéristiques complémentaires parmi les suivantes, considérées individuellement ou selon toutes les combinaisons techniquement possibles.

Dans un mode de réalisation, la couche de matériau conducteur ou semi-conducteur est en semi-conducteur dégénéré, par exemple en polysilicium, et le procédé comprend en outre, après l'étape de gravure anisotrope de la couche de liner :
- Une étape de gravure de la couche de masque dur ;
- Une étape de siliciuration de la couche de matériau semi-conducteur.

Dans un mode de réalisation, le procédé comprend comprenant, après l'étape de gravure anisotrope de la couche de liner, une étape de dépôt ou de croissance d'une couche de matériau réservoir de dopants de sorte à former les réservoirs de dopants, les ouvertures réalisées lors de la première étape de photolithographie débouchant également sur les réservoirs de dopants.

Dans la suite, lorsque le dépôt concerne le matériau réservoir de dopant, le terme dépôt pourra également désigner une croissance, même lorsqu'une telle précision n'est pas apportée.

Dans un mode de réalisation, le procédé comprend, à l'issue de la première étape de lithographie et avant l'étape de dépôt d'une couche de protection, une étape de formation des contacts dans les ouvertures réalisées lors de la première étape de lithographie.

Dans un mode de réalisation, lors de l'étape de formation des contacts, des contacts sont également formées dans les ouvertures réalisées lors de la première étape de lithographie.

Dans un mode de réalisation, l'épaisseur de la couche d'un masque dur est égale au double de l'épaisseur de la couche de matériau conducteur ou semi-conducteur.

Dans un mode de réalisation, la première étape de lithographie comprend :
- une sous-étape de gravure de la couche d'encapsulation jusqu'à la couche d'arrêt ; et
- une sous-étape de gravure de la couche d'arrêt.

Dans un mode de réalisation, la deuxième étape de photolithographie comprend :
- une sous-étape de gravure de la couche de protection et de la couche d'encapsulation jusqu'à la couche d'arrêt ; et
- une sous-étape de gravure de la couche d'arrêt.

Dans un mode de réalisation, le procédé comprend, après l'étape de dépôt d'une couche d'encapsulation, une étape de polissage mécano-chimique.

Dans un mode de réalisation, les empilements de grilles sont alignés selon un axe de référence et les ouvertures débouchant au niveau des empilements réalisées lors de la première étape de photolithographie sont déportées relativement à l'axe de référence.

Dans un mode de réalisation, le matériau espaceur est du nitrure de bore ou de l'oxyde d'aluminium.

Dans un mode de réalisation, lors de l'étape de gravure sélective de la couche du matériau espaceur, le matériau espaceur est gravé au moins cinq fois plus rapidement que les autres matériaux en présence.

Dans un mode de réalisation, lors de l'étape de gravure anisotrope de la couche de matériau espaceur, l'arrêt de la gravure se faisant sur la couche de liner.

Un deuxième aspect de l'invention concerne un dispositif semiconducteur comprenant une première couche d'oxyde, dite couche d'oxyde enterrée, une couche de silicium, un premier et un deuxième réservoirs de dopants, une pluralité de grilles principales alignées horizontalement entre le premier et le deuxième réservoirs de dopants, chaque grille principale comportant une couche de matériau conducteur ou semi-conducteur, une couche d'oxyde, la couche d'oxyde étant située entre la couche de matériau conducteur ou semi-conducteur et la couche de silicium, une pluralité de grille d'échange, chaque grille d'échange étant située entre deux grilles principales de la pluralité de grilles principales, chaque grille d'échange comportant une couche de matériau conducteur, une couche d'oxyde, la couche d'oxyde étant située entre la couche de silicium et la couche de matériau conducteur ou semi-conducteur d'une part et entre la grille d'échange considérée et les deux grilles principales situées de part et d'autre de la gille d'échange considérée, le dispositif comprenant en outre une pluralité de contacts électriques, chaque contact électrique de la pluralité de contacts électriques étant connectée à une grille d'échange et chaque contact électrique de la pluralité de contacts électriques étant situé au-dessus de la grille d'échange à laquelle il est connecté.

Avantageusement, l'axe d'alignement est un premier axe d'alignement, le dispositif comprenant en outre une deuxième pluralité de grilles principales alignées horizontalement selon un deuxième axe d'alignement parallèle au premier axe d'alignement entre le premier réservoir et le deuxième réservoir de dopants, chaque grille principale de la deuxième pluralité de grille principale comportant une couche de matériau conducteur ou semi-conducteur, une couche d'oxyde, la couche d'oxyde étant située entre la couche de matériau conducteur ou semi-conducteur et la couche de silicium, chaque grille d'échange est située entre deux grilles principales de la deuxième pluralité de grilles principales, la couche d'oxyde de la grille d'échange étant située entre la grille d'échange considérée et les deux grilles principales de la deuxième pluralité de grilles principale situées de part et d'autre de la grille d'échange considérée.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
La [Fig. 1] montre le principe de fonctionnement de deux boites quantiques séparées par une barrière de potentiel.
La [Fig. 2A] et la [Fig. 2B] illustrent un dispositif obtenu par un procédé selon l'état de la technique.
La [Fig. 3] montre un logigramme d'un procédé selon l'invention.
La [Fig. 4] montre la structure de départ du procédé selon l'invention.
La [Fig. 5] montre la structure obtenue à l'issue de l'étape de dépôt conforme d'une couche de liner.
La [Fig. 6] montre la structure obtenue à l'issue de l'étape de dépôt conforme d'une couche de matériau espaceur.
La [Fig. 7] montre la structure obtenue à l'issue de l'étape de gravure sèche de la couche de matériau espaceur.
La [Fig. 8] montre la structure obtenue à l'issue de l'étape de dépôt ou de croissance d'une couche de matériau réservoir de dopants.
La [Fig. 9] montre la structure obtenue à l'issue de l'étape de gravure de la couche de masque dur.
La [Fig. 10] montre la structure obtenue à l'issue de l'étape de siliciuration.
La [Fig. 11] montre la structure obtenue à l'issue de l'étape de dépôt d'une couche d'arrêt.
La [Fig. 12] montre la structure obtenue à l'issue de l'étape de dépôt et de planarisation d'une couche d'encapsulation.
La [Fig. 13] montre une ouverture réalisée de sorte à pouvoir contacter électriquement les réservoirs de dopants.
La [Fig. 14A] montre la position des contacts connectant les grilles principales et des contacts connectant les réservoirs de dopants dans un premier mode de réalisation.
La [Fig. 14B] montre la position des contacts connectant les grilles principales et des contacts connectant les réservoirs de dopants dans un deuxième mode de réalisation.
La [Fig. 15A] montre la structure obtenue à l'issue de la deuxième étape de lithographie au niveau des empilements de grille.
La [Fig. 15B] montre la structure obtenue à l'issue de la deuxième étape de lithographie au niveau des contact des réservoirs de dopants.
La [Fig. 16] montre la structure obtenue à l'issue de l'étape de gravure sélective de la couche d'un matériau espaceur.
La [Fig. 17A] montre la structure obtenue à l'issue de l'étape de dépôt des contacts réalisés lors de la première et de la deuxième étape de lithographie au niveau des empilements de grille.
La [Fig. 17B] montre la structure obtenue à l'issue de l'étape de dépôt des contacts réalisés lors de la première et de la deuxième étape de lithographie au niveau des contact des réservoirs de dopants.
La [Fig. 18] montre une vue de côté du dispositif susceptible d'être obtenu à l'aide d'un procédé selon l'invention.
Les [Fig. 19A] et [Fig. 19B] montre une vue de dessus du dispositif susceptible d'être obtenu à l'aide d'un procédé selon l'invention.

### DESCRIPTION DETAILLEE

Sauf précision contraire, un même élément apparaissant sur des figures différentes présente une référence unique.

### Structure de départ

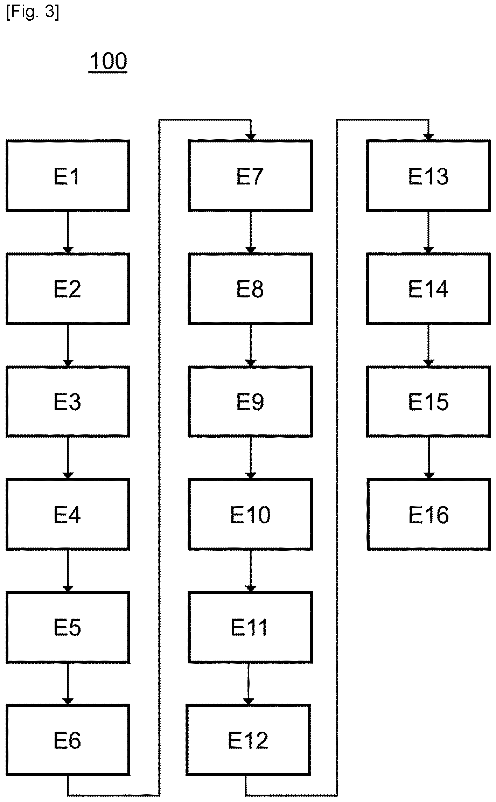

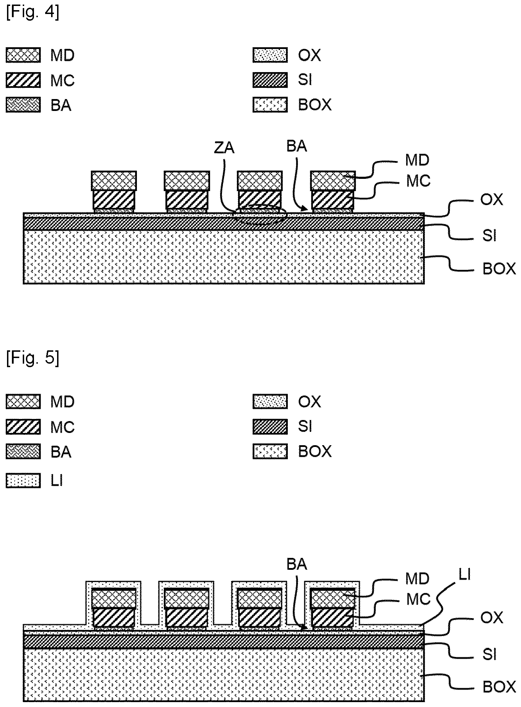

Un premier aspect de l'invention illustré à la figure 3 concerne un procédé 100 de fabrication de grilles d'échange auto-alignées. Ce procédé 100 est réalisé à partir de la structure illustrée à la figure 4. Cette structure comprend un substrat qui, dans un mode de réalisation qui servira à illustrer l'invention, comprend une première couche d'oxyde BOX, dite couche d'oxyde enterrée, une couche de silicium SI sur la première couche d'oxyde BOX et une deuxième couche d'oxyde de silicium OX sur la couche de silicium SI. Bien entendu, d'autres types de substrat peuvent être utilisés. La structure comporte en outre, disposés sur le substrat (et donc, sur les figures, sur la deuxième couche d'oxyde de silicium OX), une pluralité d'empilements de grille destinés à former les grilles principales (généralement désignées par le terme anglais « *front-gates* »), chaque empilement de grille comprenant, une couche de matériau conducteur ou semi-conducteur MC (comprenant par exemple du poly-silicium, du nitrure de titane et/ou un métal tel que le tungstène, par exemple sous le forme de plusieurs sous-couches - la couche de matériau conducteur ou semi-conducteur ou semi-conducteur MC peut donc comprendre une ou plusieurs sous-couches de matériaux conducteurs et/ou semi-conducteurs) ainsi qu'une couche d'un masque dur MD (par exemple du nitrure de silicium, de l'oxyde de silicium). Dans un mode de réalisation, l'empilement de grille comprend également une couche BA d'un métal déterminant le travail de sortie de la grille (par ex. pour définir la tension de seuil du dispositif) connue en anglais sous le terme workfunction metal. Ainsi, la deuxième couche d'oxyde de silicium OX vient constituer l'oxyde de grille de l'empilement de grille et c'est dans la couche de silicium SI sous cette deuxième couche d'oxyde OX que l'on va venir former la zone active ZA associée à chaque empilement de grille.

Dans un mode de réalisation, l'épaisseur de la couche de masque dur MD est égale au double de l'épaisseur de la couche de matériau conducteur ou semi-conducteur MC, par exemple 40nm pour une épaisseur de matériau conducteur ou semi-conducteur MC de 20 nm. Ce choix dans les épaisseurs de la couche d'un masque dur MD et de la couche de matériau conducteur ou semi-conducteur MC permet de conserver une topologie avantageuse pour les étapes de fabrication qui vont être décrites dans la suite.

Les étapes de gravure permettant d'obtenir une telle structure de départ sont connues de l'homme du métier. Généralement, la couche de masque dur MD est gravée à l'aide du CF₄ et du CH₂F₂/SF₆ lorsque cette couche est en oxyde de silicium ou en nitrure de silicium. La couche de matériau conducteur ou semi-conducteur MC est gravée à l'aide du HBr lorsque cette couche comprend une sous-couche en polysilicium et/ou à l'aide de SiCl₂/Cl₄ lorsque cette couche comprend une sous-couche en nitrure de titane. Il ne s'agit cependant que d'exemples et l'homme du métier saura adapter la méthode de gravure aux matériaux utilisés pour les différentes couches.

### Dépôt d'un espaceur bi-couche

Comme illustré à la figure 5, le procédé 100 selon un premier aspect de l'invention comprend une étape E1 de dépôt conforme d'une couche de liner LI, par exemple une couche de SiN, de SiBCN ou bien encore de SiOCN. Le dépôt peut par exemple être effectué par une méthode ALD (de l'anglais Atomic Layer Déposition ou dépôt de couches atomique en français). Dans un mode de réalisation, l'épaisseur de la couche de liner LI est comprise entre 4 nm et 5 nm. Comme cela sera détaillé dans la suite, cette couche de liner LI constituera à l'issue du procédé 100 selon l'invention l'espaceur entre les grilles principales et les grilles d'échanges que le procédé 100 selon l'invention permet d'obtenir, ainsi que la couche d'oxyde séparant chaque grille d'échange de la couche de silicium SI.

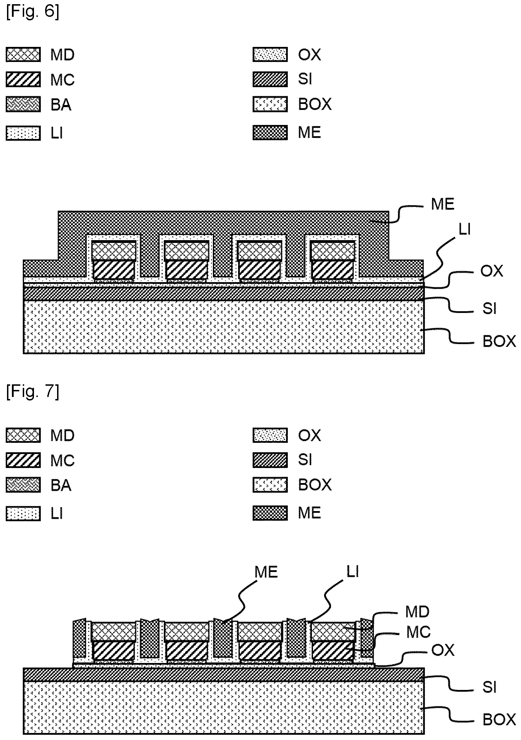

Comme illustré à la figure 6, le procédé 100 selon un premier aspect de l'invention comprend ensuite une étape E2 de dépôt conforme d'une couche d'un matériau espaceur ME, par exemple de l'oxyde de silicium ou un autre matériau que l'on peut graver sélectivement par rapport au liner LI et à la future couche d'encapsulation CE, l'épaisseur de la couche d'un matériau espaceur ME étant choisie de sorte à combler l'espace entre les empilements de grille. Par exemple, si la distance séparant deux empilements de grille est égale à 40 nm, alors l'épaisseur de la couche de matériaux espaceur ME pourra être choisie comme supérieure à 20nm, par exemple égale à 25nm.

A l'issue de ces deux étapes E1,E2, un espaceur bicouche est formé entre les empilements de grilles.

### Gravure de l'espaceur bicouche

Afin de ne conserver l'espaceur bicouche qu'entre les empilements de grille, le procédé selon un premier aspect de l'invention comprend une étape E3 de gravure anisotrope, par exemple une gravure sèche, de la couche de matériau espaceur ME, l'arrêt de la gravure se faisant sur la couche liner LI. Le procédé 100 comprend ensuite une étape E4 de gravure anisotrope, par exemple une gravure sèche de la couche liner LI. Dans un mode de réalisation, l'arrêt de la gravure se fait sur la deuxième couche d'oxyde de silicium OX, cette dernière couche pouvant cependant être consommée lors de cette étape E4 gravure. Lorsque cette couche n'est pas consommée lors de cette étape E4 de gravure, elle peut par exemple être retirée lors des préparations de surface pré-épitaxie des réservoirs, par exemple avec un procédé SiCoNi et ou à base de HF dilué. Dans une mode de réalisation, ces deux étapes E3,E4 de gravure sont réalisées par une méthode plasma fluorocarbonné.

La structure obtenue à l'issue de ces deux étapes E3,E4 est illustrée à la figure 7 pour le cas où la couche d'oxyde de silicium OX a également été consommée lors de l'étape E4 de gravure de la couche liner LI.

### Création des réservoirs de dopants (optionnel)

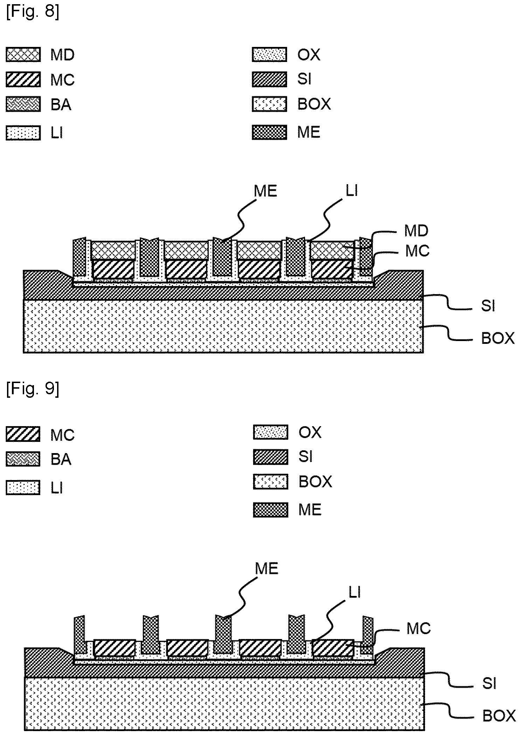

Dans un mode de réalisation, le procédé selon l'invention comprend ensuite une étape E5 de dépôt ou de croissance d'une couche d'un matériau réservoir de dopants, par exemple du Si:P (silicium dopé P) dans le cas où les charges sont des électrons et SiGe:B (alliage silicium germanium dopé au bore) dans le cas où les charges sont des trous. Cette étape est cependant facultative, la formation des réservoirs pouvant intervenir plus tard, par exemple à l'issue de la mise en œuvre du procédé 100 selon l'invention par implantation. Dans un mode de réalisation, cette étape E5 de dépôt ou de croissance est une étape de croissance par épitaxie et est, de préférence, précédée d'une étape de préparation de la surface. De préférence, lorsque la couche de matériau espaceur ME est en oxyde de silicium, la préparation de la surface avant épitaxie sera ajustée de sorte à limiter la consommation de l'oxyde de silicium. Lorsque le dépôt est effectué par épitaxie, les précurseurs peuvent être choisis parmi le SiH₄, SiH₂Cl₂, GeH₄, la température au cours de l'épitaxie étant de préférence comprise entre 650°C et 750°C. Dans un mode de réalisation, l'épaisseur de la couche d'un matériau réservoir de dopants est comprise entre 15 nm et 30 nm, de préférence égale à 20 nm. La structure obtenue à l'issue de cette étape E5 est illustrée à la figure 8 où les réservoirs de dopants sont intégrés dans la couche de silicium SI.

### Retrait du masque MD dur des empilements de grille (optionnel)

Dans un mode de réalisation, lorsque la couche de matériau conducteur ou semiconducteur MC est une couche de semi-conducteur dégénéré, par exemple en polysilicium, le procédé 100 selon l'invention comprend une étape E6 de gravure de la couche de masque dur MD. De préférence, la couche de liner LI entourant la couche de masque dur MD est également gravée lors de cette étape E6. Dans un mode de réalisation, cette étape E6 de gravure est une étape de gravure humide. Par exemple, si la couche de masque dur MD est en nitrure de silicium, l'étape E6 de gravure peut être effectuée à l'aide d'une solution de H₃PO₄, de préférence à une température de 100° C, le temps de gravure étant ajusté en fonction de l'épaisseur de la couche de masque dur MD. La structure obtenue à l'issue de cette étape E6 est illustrée à la figure 9 dans le cas où la couche de liner LI est également gravée lors de cette étape E6. Cette étape E6 est en revanche optionnelle si le matériau conducteur ou semi-conducteur MC est un métal (autrement dit si les grilles principales obtenues à partir des empilements de grille sont des grilles dites métalliques).

### Siliciuration des empilements de grille et des réservoirs de dopants (optionnel)

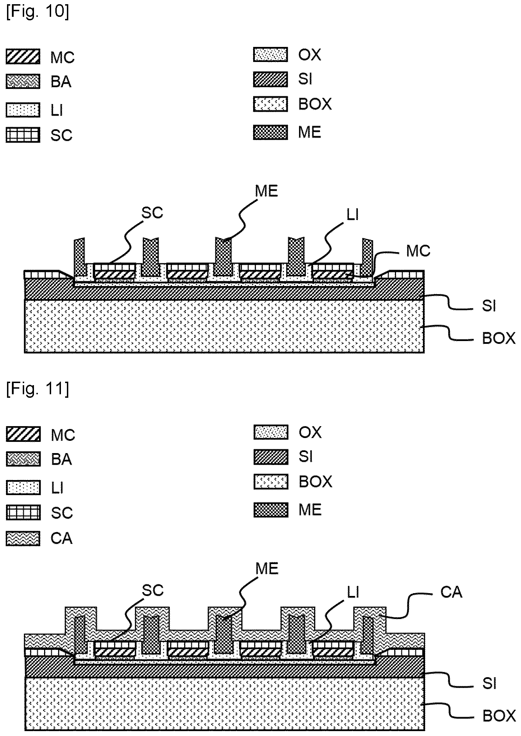

Lorsque le procédé comprend une étape E5 de dépôt ou de croissance d'une couche d'un matériau réservoir de dopants et/ou une étape E6 de gravure de la couche de masque dur MD, le procédé 100 selon l'invention comprend une étape E7 de siliciuration de la couche d'un matériau réservoir de dopant et/ou de siliciuration de la couche du matériau semi-conducteur MC. Dans un mode de réalisation, l'étape de siliciuration met en œuvre une méthode bien connue de l'homme du métier (nommée « salicidation ») comprenant une sous-étape de dépôt métallique (par exemple du NiPt10%), une sous-étape d'encapsulation (par exemple avec du TiN), une sous-étape d'un premier recuit, une sous-étape de retrait du métal n'ayant pas réagi et une sous-étape d'un deuxième recuit (la partie siliciurée est désigné par la référence SC sur les figures). Dans un mode de réalisation, lorsque la couche de matériau conducteur ou semi-conducteur MC est en semi-conducteur dégénéré, par exemple en polysilicium, l'épaisseur de siliciure obtenue est de préférence égale à la moitié de l'épaisseur de la couche d'un matériau semi-conducteur MC (par exemple comprise entre 10 nm et 15 nm). La structure obtenue à l'issue de cette étape E7 est illustrée à la figure 10 dans le cas où l'étape E5 de dépôt ou de croissance d'une couche d'un matériau réservoir de dopants et l'étape E6 de gravure de la couche de masque dur MD sont mises en œuvre.

### Encapsulation

Le procédé selon l'invention comprend ensuite une étape E8 de dépôt d'une couche d'arrêt CA (par exemple une CESL pour « Contact Etch Stop Layer » en anglais) sur l'ensemble de la structure intermédiaire obtenue à l'issue des étapes précédentes. Dans un mode de réalisation, cette étape E8 de dépôt est une étape E8 de dépôt par PECVD (pour Plasma-Enhanced Chemical Vapor Déposition en anglais ou dépôt chimique en phase vapeur assisté par plasma an français). Dans un mode de réalisation, l'épaisseur de la couche d'arrêt CA est comprise entre 20 nm et 40 nm. La structure obtenue à l'issue de cette étape est illustrée à la figure 11.

Le procédé selon l'invention comprend ensuite une étape E9 de dépôt d'une couche d'encapsulation CE, par exemple un oxyde d'encapsulation PMD (de l'anglais Poly-metal dielectric). Dans un mode de réalisation, l'oxyde d'encapsulation est du TEOS (pour orthosilicate de tétraéthyle). Dans un mode de réalisation, l'épaisseur de la couche d'encapsulation CE est comprise entre 200 nm et 350 nm, de préférence égale à 300 nm.

Dans un mode de réalisation, le procédé comprend également une étape E10 de polissage mécano-chimique de sorte à assurer une bonne planarisation de la surface de l'encapsulation.

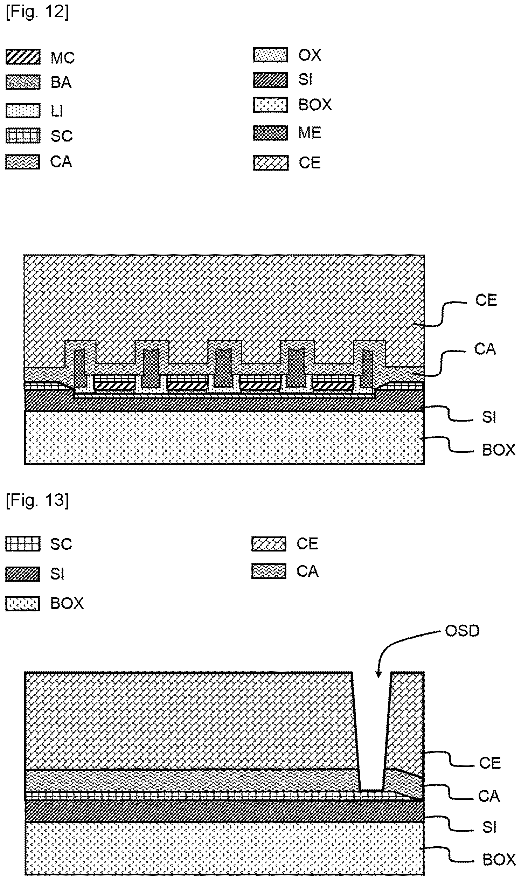

La structure obtenue à l'issue de cette étape E10 est illustrée à la figure 12.

### Motif des contacts pour les empilements de grilles et les réservoirs de dopants

Le procédé selon l'invention comprend ensuite une première étape E11 de photolithographie de sorte à réaliser les ouvertures OSD, OSC destinées à recevoir les contacts électriques des empilements de grille et au niveau des réservoirs de dopants lorsque si ces derniers ont été formés lors d'une étape précédente (la création de ces réservoirs étant optionnelle). Dans un mode de réalisation, la première étape E11 de lithographie comprend une sous-étape de gravure de la couche d'encapsulation CE jusqu'à la couche d'arrêt CA puis une sous-étape de gravure de la couche d'arrêt CA. Dans un mode de réalisation, les sous-étapes de gravure sont des sous-étapes de gravure plasma, de préférence en chimie fluorocarbonnée. La figure 13 illustre une ouverture OSD réalisée pour connecter un réservoir de dopants. Une ouverture similaire OSC est réalisée pour chaque empilement de grille afin de pouvoir contacter la couche de matériau conducteur ou semi-conducteur (rendu conducteur par la siliciuration) MC de chaque empilement de grille.

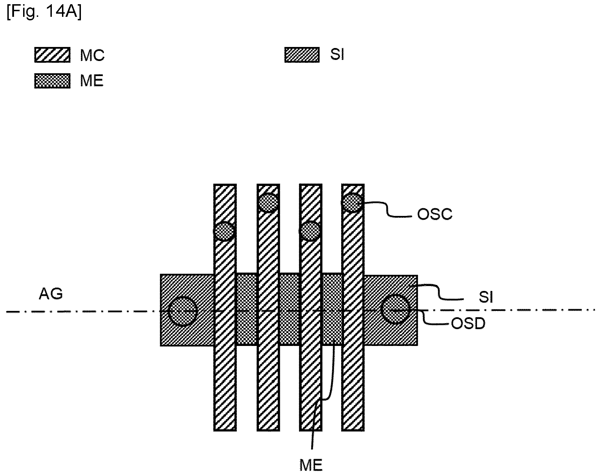

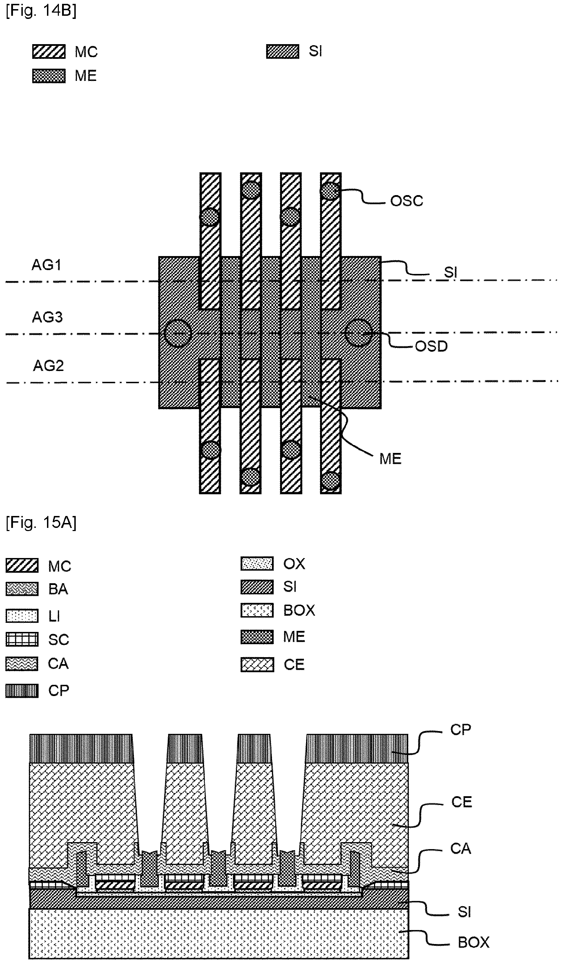

Comme illustré à la figure 14A (sur cette figure ainsi que sur la figure 14B seules les couches relatives au matériau conducteur ou semi-conducteur MC, au matériau espaceur ME et au silicium SI sont représentées pour des raisons de lisibilité), les ouvertures OSD pour les contacts des réservoirs de dopants sont réalisées dans le prolongement de l'axe d'alignement horizontal AG des empilements de grilles. En revanche, les ouvertures OSC pour les contacts des empilements de grille sont déportées par rapport à l'axe d'alignement AG des empilements de grille.

Comme illustré à la figure 14B, il est possible d'avoir la couche de silicium en commun avec une première pluralité d'empilements de grille selon un premier axe d'alignement horizontal AG1 et une deuxième pluralité d'empilements de grille selon un deuxième axe horizontal AG2 parallèle au premier axe d'alignement AG1. Dans ce mode de réalisation, les ouvertures OSD autorisant la formation des contacts des réservoirs de dopants sont réalisées dans le prolongement d'un troisième axe d'alignement horizontal AG3, situé entre le premier axe d'alignement AG1 et le deuxième axe d'alignement AG2 et parallèle à ces derniers. En revanche, les ouvertures OSC pour les contacts des empilements de grille sont déportées par rapport à l'axe d'alignement AG1, AG2 de leurs empilements de grille respectifs.

Dans un mode de réalisation, on entend par « déporté » le fait que les ouverture OSC pour autoriser la formation des contacts des empilements de grilles (et donc les contacts qui en résulteront) ne sont pas situés au-dessus des zones actives ZA associées auxdits empilements de grille. Dans un mode de réalisation, on entend par « déporté » le fait que les ouvertures OSC pour autoriser la formation des contacts d'empilements de grille (et donc les contacts qui en résulteront) ne sont pas situées au-dessus de la couche de silicium SI sur laquelle sont réalisés lesdits empilements. Par extension, un contact électrique est dit déporté lorsqu'il ne se situe pas au-dessus de la partie active de l'élément qu'il connecte.

Comme cela sera détaillé dans la suite, la couche du matériau espaceur ME sera remplacée par des électrodes, de préférence en métal, de sorte à former une pluralité de grilles d'échange GE. Ainsi, contrairement aux contacts des grilles principales, les contacts des grilles d'échanges se trouveront, à l'issue du procédé 100 selon l'invention, directement au-dessus des grilles d'échanges GE.

### Motif des contacts pour les grilles d'échange GE

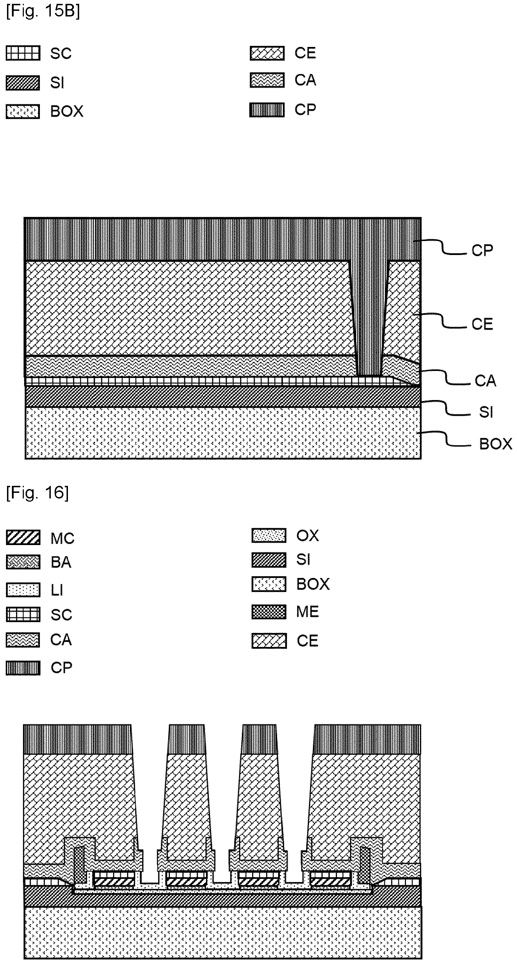

Le procédé comprend ensuite une étape E12 de dépôt d'une couche de protection CP, par exemple une couche dite SOC pour Spin-on-Carbon afin de protéger les zones exposées par les ouvertures réalisée lord de la première étape E11 de photolithographie. Le procédé 100 comprend ensuite une deuxième étape E13 de photolithographie de sorte à réaliser des ouvertures exposant la couche d'un matériau espaceur ME située entre les empilements de grille. Dans un mode de réalisation, la deuxième étape E13 de photolithographie comprend une sous-étape de gravure de la couche de protection CP et de la couche d'encapsulation CE jusqu'à la couche d'arrêt CA puis une sous-étape de gravure de la couche d'arrêt CA. Dans un mode de réalisation, les sous-étapes de gravure sont des sous-étapes de gravure sèche (par exemple plasma) avec une chimie fluorocarbonnée. La structure obtenue à l'issue de cette étape E13 est illustrée à la figure 15A pour la zone relative aux empilements de grille et à la figure 15B pour la zone relative aux ouvertures des contacts pour les réservoirs de dopants.

### Motif des grilles d'échange (auto-aligné)

Le procédé selon l'invention comprend ensuite une étape E14 de gravure sélective de la couche d'un matériau espaceur ME exposée lors de l'étape E13 de photolithographie précédente. On entend par gravure sélective le fait que le matériau espaceur ME est gravé plus rapidement, par exemple au moins cinq fois plus rapidement, de préférence au moins dix fois plus rapidement, que les autres matériaux en présence, et en particulier, plus rapidement que la couche de liner LI, la couche d'arrêt CA ou bien encore la couche d'encapsulation CE.

Dans un mode de réalisation, le matériau de l'espaceur ME est du nitrure de bore (BN) et l'étape E14 de gravure est une étape de gravure sèche, de préférence réalisée en chimie fluorocarbonnée, par exemple une étape de gravure similaire à la gravure de la couche d'encapsulation CE. Dans un mode de réalisation alternatif, le matériau de l'espaceur ME est de l'oxyde d'aluminium (AlOₓ).

Dans un mode de réalisation, le matériau espaceur ME est l'oxyde de silicium et l'étape E14 de gravure sélective est une étape de gravure humide, par exemple une gravure HF 1%. Dans ce mode de réalisation, l'étape de gravure E14 est précédée d'une étape de dépôt conforme d'une couche de protection, par exemple une couche de nitrure de silicium ou de polysilicium, suivie d'une étape de gravure anisotrope (similaire à celle utilisée pour la gravure des empilements de grille) de la couche de protection de sorte à ne conserver la couche de protection que sur les flancs des ouvertures réalisées lors de la première étape E11 de photolithographie. La structure obtenue à l'issue de ces étapes est illustrée à la figure 16. Il est utile de noter que l'obtention des ouvertures qui viendront former les grilles d'échange n'exigent pas un alignement précis lors de la deuxième étape E13 de lithographie, les zones de formation des grilles d'échanges situées entre les empilements de grilles principales étant obtenues par autoalignement lors de l'étape de gravure E14 sélective de la couche d'un matériau espaceur ME. Le procédé 100 selon l'invention garanti un très bon contrôle de la position des grilles d'échanges GE et réduit considérablement les risques de court-circuit entre les grilles d'échange et les empilements de grille GP.

### Ordre dans la réalisation des motifs

Dans ce qui vient d'être présenté, la réalisation des motifs des contacts pour les empilements de grille et les réservoirs de dopants est mise en œuvre avant la réalisation des motifs des contacts pour les grilles d'échange GE et des motifs des grilles d'échange. Cependant, l'ordre de ces étapes peut être inversé de sorte que réalisation des motifs des contacts pour les grilles d'échange GE et des motifs des grilles d'échange peut être mise en œuvre avant la réalisation des motifs des contacts pour les empilements de grille et les réservoirs de dopants. Aussi, dans l'interprétation du procédé selon l'invention, l'ordre de ces étapes ne doit pas être entendu de manière limitative.

### Contacts

Dans un mode de réalisation, le procédé 100 comprend ensuite une étape E15 de dépôt des contacts dans les ouvertures réalisées lors de la première étape E11 et de la deuxième étape E13 de lithographie et de l'étape E14 de gravure sélective de la couche du matériau espaceur ME. Dans un mode de réalisation, l'étape E15 de dépôt de contact CT comprend une sous-étape de dépôt conforme d'une couche d'adhésion, par exemple en titane, une sous-étape de dépôt conforme d'une couche d'une matériau barrière, par exemple du nitrure de titane, et une sous-étape de dépôt conforme d'un matériau conducteur, par exemple le tungstène, de sorte a rempli entièrement les ouvertures réalisées précédemment. Dans un mode de réalisation, le procédé comprend également une étape E16 de polissage mécano-chimique.

Dans un mode de réalisation alternatif, le procédé 100 comprend une étape de dépôt des contacts à l'issue de la première étape E11 de lithographie durant laquelle les contacts relatifs aux réservoirs et aux empilements de grilles sont réalisée, ces contacts étant ensuite recouverts par la couche de protection CP lors de l'étape E12 de dépôt d'une couche de protection. Le procédé comprend également une deuxième étape de dépôt des contacts à l'issue de la deuxième étape E13 de photolithographie dans les ouvertures réalisées lors de cette étape E13.

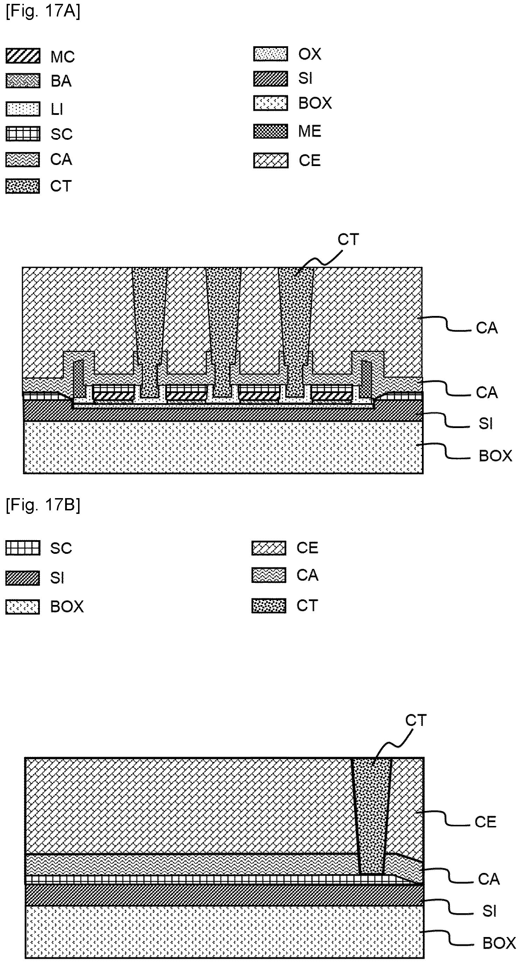

La structure obtenue à l'issue de cette étape est illustrée à la figure 17A pour des zones relatives aux empilements de grille et à la figure 17B pour la zone relative aux ouvertures des contacts pour les réservoirs de dopants. Dans cette structure, aucune grille d'échange GE n'est présente entre les réservoirs de dopants SD et la grille principale GP la plus proche desdits réservoirs SD. Il ne s'agit cependant que d'un mode particulier de réalisation et il est également possible de former, à l'aide d'un procédé selon l'invention, pour chaque réservoir de dopants SD, une grille d'échange GE séparant le réservoir de dopants SD de la grille principale GP la plus proche.

### Dispositif semi-conducteur

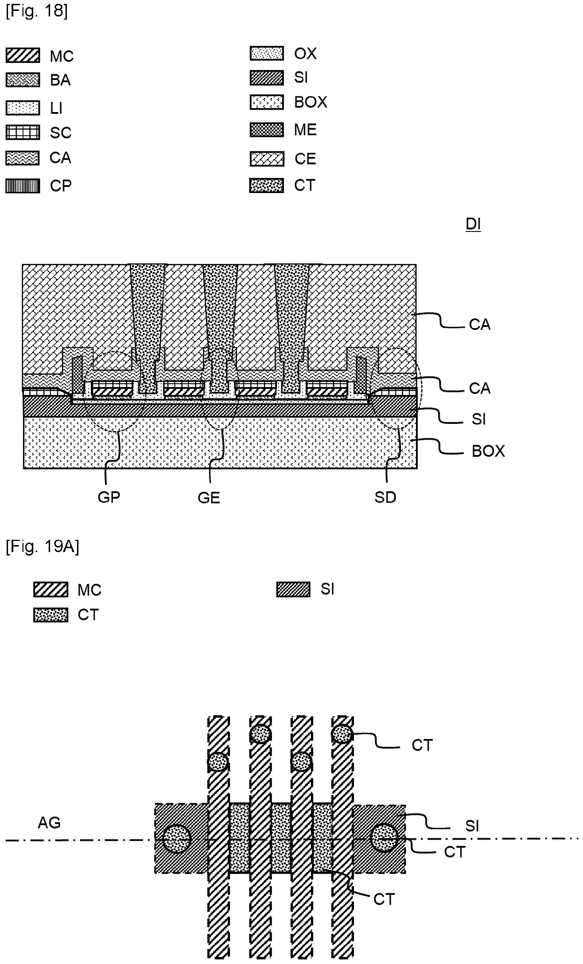

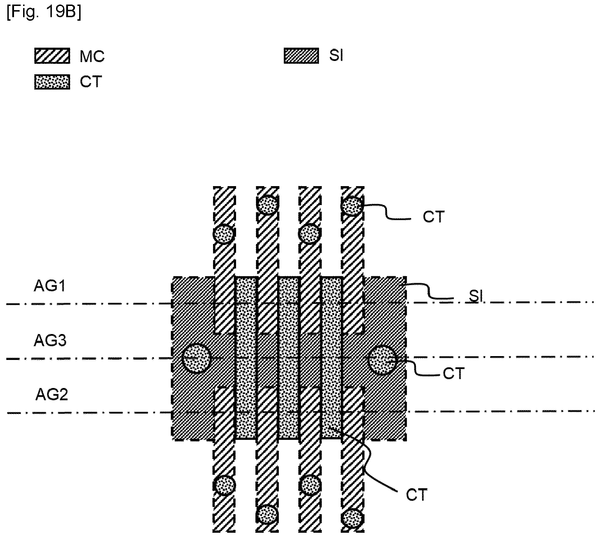

Un deuxième aspect de l'invention illustré aux figures 18, 19A et 19B (sur les figures 19A et 19B, seules les couches relatives au matériau conducteur ou semi-conducteur MC, au silicium SI et au contact CT sont représentées pour des raisons de lisibilité) concerne un dispositif semiconducteur DI susceptible d'être obtenu par un procédé selon l'invention. Le dispositif semi-conducteur DI selon l'invention comprend une première couche d'oxyde BOX, dite couche d'oxyde enterrée, une couche de silicium SI ainsi qu'un premier réservoir et un deuxième réservoir de dopants SD. Le dispositif DI selon l'invention comprend également une pluralité de grilles principales GP alignées horizontalement selon un axe d'alignement AG entre le premier réservoir et le deuxième réservoir de dopants SD, chaque grille principale GP comportant une couche d'un matériau conducteur ou semi-conducteur MC, une couche d'oxyde OX, la couche d'oxyde OX étant située entre la couche de matériau conducteur ou semi-conducteur MC et la couche de silicium SI. Le dispositif selon l'invention comprend en outre une pluralité de grille d'échange GE, chaque grille d'échange étant située entre deux grilles principales GP de la pluralité de grilles principales GP, chaque grille d'échange comportant une couche d'un matériau conducteur, une couche d'oxyde LI, la couche d'oxyde LI étant située entre la couche de silicium SI et la couche du matériau conducteur ou semi-conducteur MC d'une part et entre la grille d'échange GE considérée et les deux grilles principales GP situées de part et d'autre de la grille d'échange GE considérée.

Dans un mode de réalisation illustré à la figure 19B, le dispositif comprend également une deuxième pluralité de grilles principales GP alignées horizontalement selon un deuxième axe d'alignement AG2 parallèle au premier axe d'alignement AG1 entre le premier réservoir et le deuxième réservoir de dopants SD, chaque grille principale GP comportant une couche d'un matériau conducteur ou semi-conducteur MC, une couche d'oxyde OX, la couche d'oxyde OX étant située entre la couche de matériau conducteur ou semi-conducteur MC et la couche de silicium SI. En outre, chaque grille d'échange est située entre deux grilles principales GP de la deuxième pluralité de grilles principales GP, la couche d'oxyde LI étant située entre la grille d'échange GE considérée et les deux grilles principales GP de la deuxième pluralité de grilles principales GP situées de part et d'autre de la grille d'échange GE considérée.

Dans un mode de réalisation, le dispositif comprend une pluralité de contacts électriques chaque contact électrique de la pluralité de contacts électriques étant connecté à une grille d'échange GE, chaque contact électrique de la pluralité de contacts électriques étant situé au-dessus de la zone active de la grille d'échange GE à laquelle il est connecté. Autrement dit, les contacts électriques associés aux grilles d'échanges ne sont pas déportés, mais se trouve au-dessus desdites grilles d'échange, ce qui permet d'augmenter la densité de dispositifs.

Dans le dispositif illustré sur les figures, aucune grille d'échange GE n'est présente entre les réservoirs de dopants SD et la grille principale GP la plus proche desdits réservoirs SD. Il ne s'agit cependant que d'un mode particulier de réalisation et le dispositif selon l'invention peut également comprendre, pour chaque réservoir de dopants SD, une grille d'échange GE séparant le réservoir de dopants SD de la grille principale GP la plus proche.

## Revendications

1. Procédé (100) de fabrication de grilles d'échange (GE) à partir d'une structure de départ comprenant un substrat et, disposés sur le substrat, une pluralité d'empilements de grille, chaque empilement de grille comprenant, une couche d'un matériau conducteur ou semi-conducteur (MC) ainsi qu'une couche d'un masque dur (MD), le procédé (100) comprenant :
- une étape (E1) de dépôt conforme d'une couche de liner (LI) sur la structure de départ ;
- une étape (E2) de dépôt conforme d'une couche d'un matériau espaceur (ME) sur la couche de liner (LI), l'épaisseur de la couche d'un matériau espaceur (ME) étant choisie de sorte à combler l'espace entre les empilements de grille ;
- une étape (E3) de gravure anisotrope de la couche de matériau espaceur (ME) ;
- une étape (E4) de gravure anisotrope de la couche de liner (LI) ;
- une étape (E8) de dépôt d'une couche d'arrêt (CA) sur l'ensemble de la structure intermédiaire obtenue à l'issue des étapes précédentes ;
- une étape (E9) de dépôt d'une couche d'encapsulation (CE) sur la couche d'arrêt (CA) ;
- une première étape (E11) de photolithographie de sorte à réaliser, dans la couche d'arrêt (CA) et la couche d'encapsulation (CE), des ouvertures (OSD, OSC) débouchant au niveau des empilements de grille, les ouvertures (OSD, OSC) étant destinées à recevoir des contacts électriques ;
- une étape (E12) de dépôt d'une couche de protection (CP) de sorte à protéger les zones exposées lors de la première étape (E11) de lithographie ;
- une deuxième étape (E13) de photolithographie réalisant des ouvertures exposant la couche d'un matériau espaceur (ME) située entre les empilements de grille ;
- une étape (E14) de gravure sélective de la couche du matériau espaceur (ME) exposée lors de l'étape (E13) de photolithographie précédente ;
- une étape de formation des contacts (CT) dans les ouvertures réalisées lors de la première étape (E11) de photolithographie, de la deuxième étapes de photolithographie (E13) et de l'étape (E14) de gravure sélective de la couche du matériau espaceur (ME) de sorte à obtenir les grilles d'échange (GE).

2. Procédé (100) selon la revendication précédente, dans lequel la couche de matériau conducteur ou semi-conducteur (MC) est en semi-conducteur dégénéré, le procédé (100) comprenant en outre, après l'étape (E4) de gravure anisotrope de la couche de liner (LI) :
- une étape (E6) de gravure de la couche de masque dur (MD), la couche du matériau semi-conducteur (MC) ;
- une étape (E7) de siliciuration de la couche de matériau semi-conducteur.

3. Procédé selon l'une des revendications précédentes comprenant, après l'étape (E4) de gravure anisotrope de la couche de liner (LI), une étape (E5) de dépôt ou de croissance d'une couche de matériau réservoir de dopants de sorte à former les réservoirs de dopants, les ouvertures réalisées lors de la première étape (E11) de photolithographie débouchant également sur les réservoirs de dopants.

4. Procédé (100) selon l'une des revendications précédentes dans lequel l'épaisseur de la couche d'un masque dur (MD) est égale au double de l'épaisseur de la couche d'un matériau conducteur ou semi-conducteur (MC).

5. Procédé (100) selon l'une des revendications dans lequel la première étape (E11) de lithographie comprend :
- une sous-étape de gravure de la couche d'encapsulation (CE) jusqu'à la couche d'arrêt (CA) ; et
- une sous-étape de gravure de la couche d'arrêt (CA).

6. Procédé (100) selon l'une des revendications précédentes dans lequel la deuxième étape (E13) de photolithographie comprend :
- une sous-étape de gravure de la couche de protection (CP) et de la couche d'encapsulation (CE) jusqu'à la couche d'arrêt (CA) ; et
- une sous-étape de gravure de la couche d'arrêt (CA).

7. Procédé (100) selon l'une des revendications précédentes comprenant, après l'étape (E9) de dépôt d'une couche d'encapsulation, une étape de polissage mécano-chimique.

8. Procédé (100) selon l'une des revendications précédentes dans lequel les empilements de grilles sont alignés selon un axe de référence et dans lequel les ouvertures (OSC) débouchant au niveau des empilements réalisées lors de la première étape (E11) de photolithographie sont déportées relativement à l'axe de référence.

9. Procédé selon l'une des revendications précédentes dans lequel le matériau espaceur (ME) est du nitrure de bore ou de l'oxyde d'aluminium.

10. Procédé selon l'une des revendications précédentes dans lequel, lors de l'étape (E14) de gravure sélective de la couche du matériau espaceur (ME), le matériau espaceur (ME) est gravé au moins cinq fois plus rapidement que les autres matériaux en présence.
